(19) **Europäisches Patentamt**
**European Patent Office**
**Office européen des brevets**

(11) **EP 4 501 501 A1**

(12) **EUROPEAN PATENT APPLICATION**
published in accordance with Art. 153(4) EPC

(43) Date of publication:
**05.02.2025 Bulletin 2025/06**

(21) Application number: **23780011.5**

(22) Date of filing: **23.03.2023**

(51) International Patent Classification (IPC):
**B23B 27/14** (2006.01)     **C23C 16/34** (2006.01)
**C23C 16/36** (2006.01)

(52) Cooperative Patent Classification (CPC):
**B23B 27/14; C23C 16/34; C23C 16/36**

(86) International application number:
**PCT/JP2023/011414**

(87) International publication number:
**WO 2023/190000 (05.10.2023 Gazette 2023/40)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **30.03.2022   JP 2022056505**

(71) Applicant: **Mitsubishi Materials Corporation
Tokyo 100-8117 (JP)**

(72) Inventors:
• **YANAGISAWA Kosuke
  Tokyo 100-8117 (JP)**
• **HOMMA Hisashi
  Tokyo 100-8117 (JP)**

(74) Representative: **Gille Hrabal
Partnerschaftsgesellschaft mbB
Patentanwälte
Brucknerstraße 20
40593 Düsseldorf (DE)**

(54) **SURFACE-COATED CUTTING TOOL**

(57)    A surface coated cutting tool comprises a substrate and a coating layer, where (a) the coating layer comprises a complex nitride or carbonitride layer; (b) the complex nitride or carbonitride is $(Al_X V_Y Ti_{1-X-Y})(C_\alpha N_{1-\alpha})$ (wherein the average values $X_{avg}$, $Y_{avg}$ and $\alpha_{avg}$ of X, Y and $\alpha$, satisfy the relations: $0.600 \leq X_{avg} \leq 0.950$, $0.010 \leq Y_{avg} \leq 0.300$, $0.610 \leq X_{avg} + Y_{avg} \leq 0.990$ and $0.0000 \leq \alpha_{avg} \leq 0.0050$); (c) the complex nitride or carbonitride comprises crystal grains containing a variable amount X of Al, wherein the average $X_{max}$ of the maxima $X_{max}^*$ and the average $X_{min}$ of the minima $X_{min}^*$ of X in the crystal grains satisfy the relations: $0.020 \leq X_{max} - X_{min}$ 0.400, and $0.020 \leq X_{max} - X_{min} \leq 0.400$, and (d) $A^*$ (nm) $= 0.4045 X_{avg} + 0.4130 Y_{avg} + 0.4242 (1 - X_{avg} - Y_{avg})$ and the lattice constant A (nm) calculated from an XRD pattern satisfy the relation: $|A - A^*| < 0.0010$ (nm).

[Fig. 1]

## Description

### Technical Field

The present invention relates to a surface coated cutting tool (hereinafter referred to as "coated tool"). This application claims priority based on Japanese Patent Application No. 2022-56505 filed on March 30, 2022. The entire description in the Japanese patent application is hereby incorporated by reference.

### Background Art

Coated tools are known that includes coating layers formed on the surfaces of substrates composed of, for example, tungsten carbide (hereinafter denoted by WC) based cemented carbide. Such coated tools exhibit high wear resistance. Various proposals have also been made to improve the coating layers.

For example, Patent Literature 1 discloses a coated tool including a substrate and a wear-resistant coating layer formed on the substrate. This wear-resistant coating layer has a composition: $(Ti_x, Al_y, V_z)(C_u, N_v, O_w)$ (where $x+y+z = 1$, $u+v+w = 1$, $0.2 < x < 1$, $0 \leq y < 0.8$, $0.02 \leq z < 0.6$, $0 \leq u < 0.7$, $0.3 < v \leq 1$ and $0 \leq w < 0.5$), and has a thickness of 0.5 μm or more and 15 μm or less. The coated tool has improved wear resistance.

### Citation List

### Patent Literature

PTL1: Japanese Patent Application Unexamined Publication No. H10-237628

## Summary of Invention

### Technical Problem

An object of the present invention, which was made in view of the aforementioned circumstances and proposal, is to provide a coated tool having high chipping resistance, thermal crack resistance, and wear resistance, even during high-speed intermittent cutting, for example.

### Solution to Problem

A surface coated cutting tool according to an embodiment of the present invention comprises a substrate and a coating layer on a surface of the substrate, wherein

(a) the coating layer comprises a complex nitride or carbonitride layer of Ti, Al and V in a form of columnar crystal grains of a NaCl-type face-centered cubic structure,
(b) the complex nitride or carbonitride is represented by the formula: $(Al_X V_Y Ti_{1-X-Y})(C_\alpha N_{1-a})$ (wherein the average values $X_{avg}$, $Y_{avg}$ and $\alpha_{avg}$ of X, Y and $\alpha$, satisfy the relations: $0.600 \leq X_{avg} \leq 0.950$, $0.010 \leq Y_{avg} \leq 0.300$, $0.610 \leq X_{avg} +_{Yavg} \leq 0.990$ and $0.0000 \leq \alpha_{avg} \leq 0.0050$),
(c) the complex nitride or carbonitride comprises crystal grains containing a variable amount X of Al, wherein the average $X_{max}$ of the maxima $X_{max}^*$ and the average $X_{min}$ of the minima $X_{min}^*$ of X in the crystal grains satisfy the relations: $0.020 \leq X_{max}-X_{min} \leq 0.400$, and $0.020 \leq X_{max}-X_{min} \leq 0.400$, and
(d) A* (nm) represented by $A^* = 0.4045 X_{avg} + 0.4130 Y_{avg} + 0.4242 (1-X_{avg}-Y_{avg})$ and the lattice constant A (nm) calculated from an XRD pattern satisfy the relation: $|A-A^*| < 0.0010 (nm)$.

The surface coated cutting tool according to the embodiment may satisfy aspect (1) below.
(1) The complex nitride or carbonitride layer comprises crystal grains containing both a variable amount of Al and a variable amount of V, and the average $Y_{max}$ of the maxima $Y_{max}^*$ and the average $Y_{min}$ of the minima $Y_{min}^*$ of Y satisfy the relation: $0.010 \leq Y_{max}-Y_{min} \leq 0.200$.

### Advantageous Effects of Invention

The surface-coated tools have improved chipping resistance, thermal cracking resistance, and wear resistance.

**Brief Description of Drawings**

Fig. 1 is a schematic diagram illustrating an exemplary longitudinal section of a surface-coated cutting tool.
Fig. 2 is a schematic perspective view of a portion of a gas supply pipe of an exemplary apparatus of manufacturing a surface-coated cutting tool.
Fig. 3 is a cross-sectional schematic diagram of the gas supply pipe in Fig. 2.

**Description of Embodiments**

The inventor has intensively studied improvements in thermal cracking resistance and wear resistance of a complex nitride or carbonitride layer of Al, V and Ti (hereinafter referred to as "(AlVTi)CN"), for example, in high-speed intermittent cutting at a cutting speed of 300 m/min or higher with inserts. As a result, the inventor has found the following facts: Mere coating of an (AlVTi)CN layer cannot lead to sufficient chipping resistance, thermal crack resistance, or wear resistance of the tool. However, the chipping resistance, thermal crack resistance, and wear resistance of the composite nitride layer are improved if a predetermined relationship is established between the lattice constant calculated based on the composition in accordance with Vegard's law and the lattice constant determined from XRD.

The inventor also has found the following facts: In the case that crystal grains containing a variable amount of Al (variable composition) are present and that a difference between the maximum value and the minimum value lies within a predetermined range, thermal cracking resistance and chipping resistance are improved. Furthermore, in the case that a variable V content (variable composition) in crystal grains containing a variable amount of Al (variable composition) has a difference between the maximum value and the minimum value within a predetermined range, thermal cracking resistance and chipping resistance are further improved.

The surface-coated cutting tools according to embodiments of the present invention will now be described.

Throughout the specification and the claims, a numerical range expressed as "L to M" (L and M are both numerical values) is synonymous with "L or more and M or less," and the range includes the upper limit (M) and the lower limit (L). The units stated only for the upper limit indicates that the upper limit (M) and the lower limits (L) have the same units.

1. Coating Layer

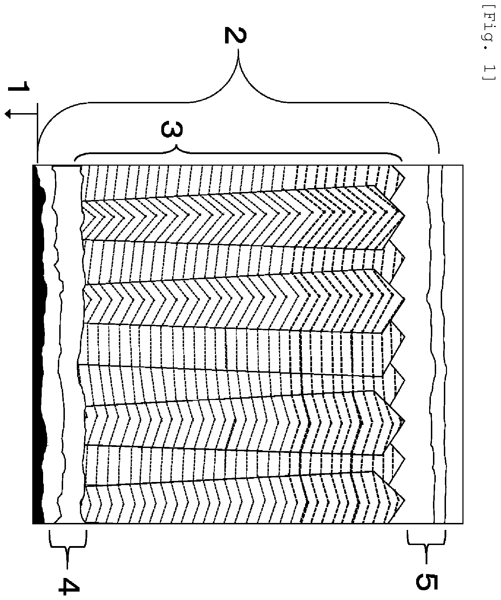

With reference to Fig. 1, the coating layer (2) on the substrate (1) includes an (AlTiV)CN layer (3), and may further includes at least one underlying layer (4) and at least one overlying layer (5). The underlying layer (4) and overlying layer (5) are not essential. These layers will now be described in sequence.

1-1. (AlTiV)CN layer

The (AlVTi)CN layer, which is always included in the coating layer, will be described.

(1) Average thickness

In this embodiment, the (AlVTi)CN layer preferably has an average thickness of 1.0 to 20.0 $\mu$m for the following reasons: An average thickness of less than 1.0 $\mu$m fails to achieve the thermal crack resistance and wear resistance to be provided by this layer, while an average thickness exceeding 20.0 $\mu$m causes the chipping resistance to decrease. A more preferred average thickness is within a range of 3.0 to 15.0 $\mu$m.

(2) Shape of crystal grains

The (AlVTi)CN layer preferably contains columnar crystal grains of a NaCl-type face-centered cubic structure in the longitudinal section described below. The columnar crystal grains are defined as ones with an aspect ratio of 1.5 or more for the following reasons: Columnar crystal grains have fewer grain boundaries oriented in a direction parallel to the substrate, which orientation can reduce chipping originating from these grain boundaries.

The NaCl-type face-centered cubic structure of columnar crystal grains with an aspect ratio of 1.5 or more preferably occupies 50 area percent or more in the longitudinal section. 50 area percent or more (even 100 area percent) is sufficient to prevent occurrence of chipping.

The aspect ratio is more preferably 2.0 or more. The columnar crystal grains having a NaCl-type face-centered cubic structure with an aspect ratio of 2.0 or more is more preferably occupy 70 area percent or more in the longitudinal section for the following reasons:

The occurrence of chipping can be more effectively reduced at 70 area percent or more (may be 100 area percent, i.e., all crystal grains may have a columnar structure with an aspect ratio of 2.0 or more).

The longitudinal section is defined by a cross-section perpendicular to the substrate where the substrate is considered to have a flat surface without irregularity in an insert, or by a cross-section perpendicular to the axis in a shaft tool.

Although no restriction is provided on the upper limit of the aspect ratio, an upper limit of 10.0 is more preferable. An aspect ratio exceeding 10.0 causes the columnar crystal structure to fracture readily and large chipping to occur. The method of calculating the aspect ratio will be described later.

(3) Composition

(3-1) Average composition

The (AlVTi)CN layer preferably has a composition represented by the formula: $(Al_X V_Y Ti_{1-X-Y})(C_\alpha N_{1-\alpha})$, where the average values $X_{avg}$, $Y_{avg}$, and $\alpha_{avg}$, of X, Y and $\alpha$, respectively, satisfy the relations: $0.600 \leq X_{avg} \leq 0.950$, $0.010 \leq Y_{avg} \leq 0.300$, $0.610 \leq X_{avg} + Y_{avg} \leq 0.990$, and $0.0000 \leq \alpha_{avg} \leq 0.0050$.

The reason for determining the average value $X_{avg}$ within such a range is as follows: An average value $X_{avg}$ of less than 0.600 leads to insufficient hardness and decreased wear resistance of the (AlVTi)CN layer, while an average value $X_{avg}$ exceeding 0.950 leads to undesirable formation of the hexagonal structure of wurtzite in the layer, resulting in abnormal damage such as uneven wear.

The reason for determining the average value $Y_{avg}$ within such a range is as follows: An average value $Y_{avg}$ of less than 0.010 leads to an insufficient improvement in lubricity of the (AlVTi)CN layer, while an average value $Y_{avg}$ exceeding 0.300 leads to insufficient hardness and low wear resistance of the layer.

The reason for determining the average sum $X_{avg} + Y_{avg}$ within such a range is as follows: The lower limit satisfies the lower limits of average values $X_{avg}$ and $Y_{avg}$, while an average sum exceeding 0.990 leads to insufficient hardness of the (AlVTi)CN layer, resulting in lower wear resistance.

The values $X_{avg}$ and $Y_{avg}$ and the average sum $X_{avg} + Y_{avg}$ more preferably satisfy the relations: $0.760 \leq X_{avg} \leq 0.900$, $0.020 \leq Y_{avg} \leq 0.050$, and $0.780 \leq X_{avg} + Y_{avg} \leq 0.950$, respectively.

The reason for determining the average value $\alpha_{avg}$ within the above-described range is as follows: An average value $\alpha_{avg}$ is within this range leads to an improvement in wear resistance of the (AlVTi)CN layer, while an average value $\alpha_{avg}$ deviating from this range leads to abnormal damage, such as uneven wear of the layer. More preferable range is $0.0020 \leq \alpha_{avg} \leq 0.0035$.

Cl is inevitably contained during the manufacturing process. Preferably, the percentage Z of the number of Cl atoms to the total number of Al, Ti, V, C, N and Cl atoms is more than 0.005 atomic percent and less than 0.500 atomic percent, for the following reasons: A Cl content of less than 0.005 atomic percent leads to insufficient lubricity and low wear resistance of the (AlVTi)CN layer. A Cl content of more than 0.500 atomic percent leads to insufficient wear resistance of the rake face of the layer, resulting in premature wear. It is even more preferable that Z be greater than 0.005 atomic percent and less than 0.100 atomic percent.

(3-2) Variable amount

It is preferable for improvements in thermal cracking resistance and chipping resistance that crystal grains contain a variable amount X of Al (having a non-uniform composition) and that the average $X_{max}$ of the maxima $X_{max}*$ and the average $X_{min}$ of the minima $X_{min}*$ of the variable amount X of Al in the crystal grains satisfy $0.020 \leq X_{max}-X_{min} \leq 0.400$. It is more preferable for further improvements in thermal cracking resistance and chipping resistance that these crystal grains containing variable amount of Al also contains a variable amount Y of V and the average $Y_{max}$ of the maxima $Y_{max}*$ and the average $Y_{min}$ of the minima $Y_{min}*$ of the variable amount Y of V in the crystal grains satisfy $0.010 \leq Y_{max}-Y_{min} \leq 0.200$. The symbol "*" indicates that the value determined from each crystal grain.

The crystal grains containing only a variable amount of Al or both variable amounts of Al and V are present in preferably 50 area percent or more, more preferably 70 area percent or more (may be 100 area%) in the longitudinal section, for the following reason: A percentage of less than 70 area percent may cause the coated tool to have lower resistance to thermal cracking and chipping when subjected to high-speed intermittent cutting.

(3-3) Ratio of $(C_\alpha N_{1-\alpha})$ to $(Al_X V_Y Ti_{1-X-Y})$

The crystal grains may have any ratio of $(C_\alpha N_{1-\alpha})$ to $(Al_X V_Y Ti_{1-X-Y})$ Preferably, the ratio of $(C_\alpha N_{1-\alpha})$ to $(Al_X V_Y Ti_{1-X-Y})$ is 0.8 to 1.2, for the following reason: A ratio of $(C_\alpha N_{1-\alpha})$ to $(Al_X V_Y Ti_{1-X-Y})$ within such a range contributes to more reliable achievement of the inventive object.

(3-4) NaCl-type face-centered cubic structure

The (AlVTi)CN layer should preferably contain crystal grains of a NaCl-type face-centered cubic structure. In detail, in the longitudinal section, the percentage of crystal grains of a NaCl-type face-centered cubic structure should preferably be 50 area percent or more, more preferably 70 area percent or more. All the crystal grains (100% area) may have a NaCl-type face-centered cubic structure.

(4) Difference in lattice constant

The difference between the lattice constant ($A*$ (nm)) determined from the composition of the (AlVTi)CN layer and the lattice constant ($A$ (nm)) determined from XRD should be within a predetermined value. In detail, it is preferable to satisfy the relation: $|A-A*| < 0.0010$ (nm). A difference in lattice constant of greater than 0.0010 (nm) causes the number of crystal grains having a crystal structure other than the NaCl-type face-centered cubic structure to increases and the wear resistance of the (AlVTi)CN layer to decrease.
In the relation, $A*$ is derived from the following expression in accordance with Begard's law:

$$A* = 0.4045X + 0.4130Y + 0.4242(1-X-Y).$$

Another parameter A is defined by the following calculation: The substrate is removed as much as possible from the (AlVTi) CN layer by polishing or etching to eliminate the effect of residual stress; the (AlVTi)CN layer is pulverized; the resulting powder is subjected to powder X-ray diffractometry; the spacing d(111) and spacing d(200) are calculated from the diffraction angles of the 111 and 200 diffraction lines of the resulting X-ray diffraction pattern; and then A(111) and A(200) are calculated and averaged from the relations: $A(111) = \sqrt{3}d(111)$ and $A(200) = 2d(200)$.
The X-ray diffraction pattern is determined, for example, by the $2\theta$-$\theta$ method with CuK$\alpha$ rays with a Spectris PANalytical Empyrean X-ray diffractometer, under the following conditions: a scanning range ($2\theta$) of 15 to 135 degrees, X-ray outputs of 45 kV and 40 mA, a divergence slit of 0.5 degrees, a scan step of 0.013 degrees, and a measuring time per step of 0.16 sec/step.
The diffraction angle is calculated by a WPPD method (Whole-powder-pattern Decomposition method: see, for example, Bulletin of the Japan Institute of Metals, Vol. 28, No. 3 (1989), p. 189).

1-2. Other layers

Although the (AlVTi)CN layer according to the embodiment is sufficient by itself to achieve the object of the invention, at least one underlying layer and/or at least one overlying layer may also be provided.

(1) Underlying layer

The underlying layer consists of at least one Ti compound sublayer (the composition of these Ti compound sublayers is not limited to stoichiometric composition) selected from the group consisting of titanium carbide, nitride, carbonitride, and carbonitride layers, and has a total average thickness of 0.1 to 20.0 $\mu$m. The underlying layer improves the adhesion between the (AlVTi)CN layer and the substrate.

(2) Overlying layer

The overlying layer includes an aluminum oxide (not limited to stoichiometric composition) sublayer, and has a total average thickness of 0.1 to 25.0 $\mu$m. The overlying layer improves wear resistance of the tool.

(3) Unintended layers

Although layers other than the underlying layer, (AlVTi)CN layer, and overlying layer are not intentionally deposited in this embodiment, unintended layers different from these layers may be deposited due to an unpredictable change in pressure or temperature in the furnace upon switching of deposition gases.

2. Substrate

(1) Material

Any known material can be used that is suitable for the substrate of the invention. Example materials include WC-based cemented carbides (containing Co in addition to WC, and also containing carbides of Ti, Ta, and Nb), cermet (mainly composed of TiC, TiN, and TiCN), ceramics (titanium carbide, silicon carbide, silicon nitride, aluminum nitride, and aluminum oxide), and cBN sintered bodies.

(2) Shape

The substrate may have any shape suitable for cutting tools without particular restrictions. Examples include shapes of inserts and drills.

3. Production

The (AlVTi)CN layer of the embodiment can be produced by a CVD process using, for example, gas group A containing $NH_3$, Ar, and $H_2$ and gas group B containing $TiCl_4$, $VCl_4$, $AlCl_3$, Ar, $N_2$, $C_2H_4$, and $H_2$.

The gas group A and gas group B are fed separately just before they reach the substrate in the space inside the reaction vessel of the thermal CVD system. The gas group A and B are then mixed just before they reach the substrate in the reaction vessel to be allowed to react. This is an effective method for uniformly distributing gas species with high reactivity over the entire deposition area. The technical details are disclosed, for example, in Japanese Patent No. 6358420.

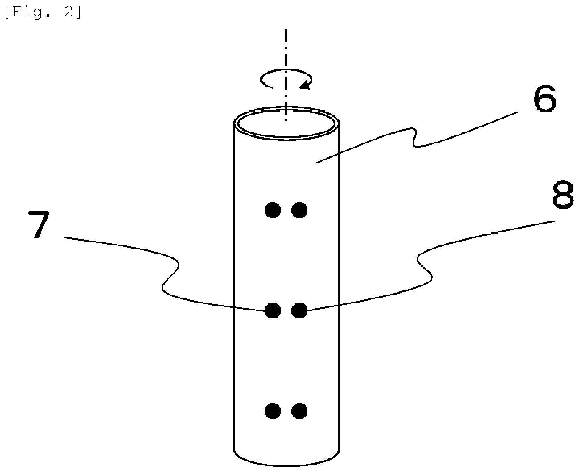

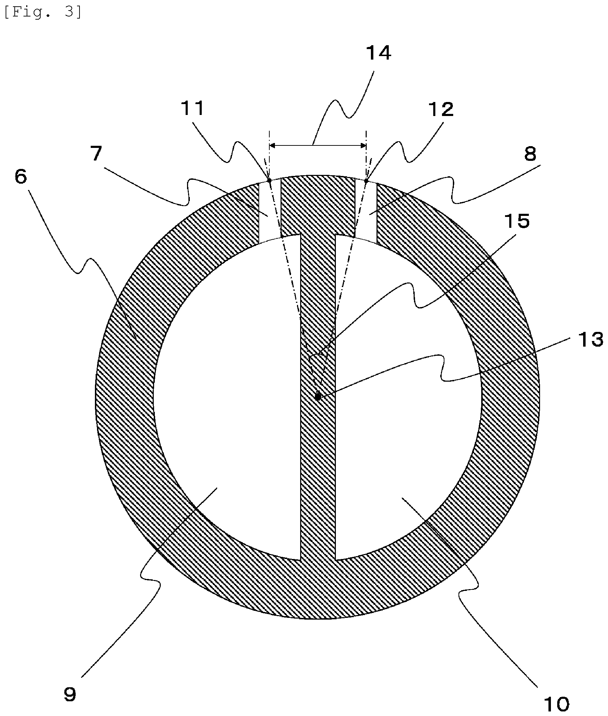

The deposition system described in the patent has a gas supply pipe shown in Figs. 2 and 3. The gas supply pipe (6), which is a cylindrical pipe rotating at a predetermined rotational rate around its center, is separated into approximately two equal sections by a partition extending along its axis into a gas group A distribution segment (9) and a gas group B distribution segment (10).

The gas supply pipe (6) has several nozzles for gas group A (7) and several nozzles for gas group B (8) along the axis, which nozzles constitute pairs at approximately the same height, as shown in Fig. 2.

The nozzles for gas group A (7) and the nozzles for gas group B (8) shown in Fig. 3 belong to the same pair, and the distance (14) between the center (11) of the outer opening end of the nozzle for the gas group A (7) and the center (12) of the outer opening end of the nozzle for gas group B (8) has a predetermined value. The angle (15) between the center (11) of the outer circumferential opening end of the nozzle for the gas group A (7), the center of the rotation axis of the gas supply pipe (13), and the center (12) of the outer circumferential opening end of the nozzle for gas group B (8), projected onto a plane perpendicular to the rotation axis, is also established to a predetermined value.

4. Measurement

The measurement for each of the values in this embodiment will now be described.

Throughout the description, the longitudinal section refers to a cross-section perpendicular to the face of the substrate where the face is regarded as flat with minute irregularities on the surface of the substrate being ignored in an insert. The substrate surface is defined by an average line (straight line) of the rough interface between the substrate and the coating layer in an observed image of the longitudinal section. The direction perpendicular to this average line shall be the direction perpendicular to the substrate (thickness direction of the coating layer).

Even in the case of a substrate having a curved surface, such as substrate of a drill, a similar technique can be applied to determine the surface of the substrate.

The longitudinal section is prepared by polishing the coating layer with a focused ion beam (FIB) system, a cross-section polisher (CP), for example.

(1) Average thickness

The longitudinal section (the longitudinal section preferably including the flank in the case that the coated tool is an insert) is observed with a scanning electron microscope over a rectangular region defined by 100 $\mu$m in the horizontal direction (parallel to the substrate surface) and the entire thickness of the coating layer in the longitudinal direction (the thickness direction of the coating layer). The thickness is observed at several points (for example, five points) and observed data are averaged as an average thickness.

(2) Percentage of area occupied by crystal grains of a NaCl-type face-centered cubic structure and columnar crystal grains with an aspect ratio of 1.5 and 2.0 or greater.

In the observed area of the longitudinal section, an electron beam backscattered diffraction (EBSD) system is used to irradiate the observed area that includes, for example, the entire thickness of the (AlTiV)CN layer and contains 20 or more crystal grains with electron beams at an incident angle of 70 degrees, an acceleration voltage of 15kV, and an irradiation current of 1 nA at an interval of 0.01 $\mu$m. The boundaries of regions with different crystal structures are delineated and crystal grains are identified by analysis of the crystal structure based on the electron beam backscattered diffraction images.

The crystal structure is analyzed to determine the area percent of crystal grains that are confirmed to have a NaCl-type face-centered cubic structure.

Each crystal grain i confirmed to have a NaCl-type face-centered cubic structure is subjected to image analysis to determine the maximum length Hi in the direction perpendicular to the surface of the substrate (the direction perpendicular to the deemed flat surface of the substrate) in this crystal grain i, the maximum width Wi in the direction horizontal to the substrate (the direction parallel to the deemed flat surface of the substrate) in this grain i, and the maximum area Si of the crystal grain i. The aspect ratio Ai = Hi/Wi of the crystal grain i is then calculated. The aspect ratio A of crystal grains is then determined by Expression 1:

$$A = \frac{A_1 S_1 + A_2 S_2 + A_3 S_3 + \cdots + A_n S_n}{S_1 + S_2 + S_3 + \cdots + S_n} \qquad (1)$$

where n is 20 or more.

(3) Values X, Y and $\alpha$

Values X and Y, which define the composition of the (AlVTi) CN layer, are determined by irradiation of the surface of a longitudinal section of a polished sample of the (AlVTi)CN layer with an electron beam (beam diameter of 1 $\mu$m) with an electron probe micro analyzer (EPMA), for example. The results of the characteristic X-ray analysis are averaged over ten points. Alternatively, the composition of the (AlVTi)CN layer is determined by an energy dispersive X-ray spectroscopy (EDS). The polished surface of the longitudinal section of the (AlVTi) CN layer is irradiated with an electron beam from the longitudinal section, and multiple line analyses (e.g., five lines) are performed in the direction of the thickness of the (AlVTi) CN layer to determine the contents of Al, Ti, and V and to average the results of the five lines.

$\alpha$ is determined by secondary ion mass spectrometry (SIMS). In detail, the depth profile of the (AlVTi)CN layer is determined by alternately repeating surface analysis with an ion beam and etching with a sputter ion beam. The C and N contents are measured at any ten measuring points at a depth of at least 1 $\mu$m from the surface of the coating layer of the (AlVTi)CN layer and are averaged (referred to as site average). That is the C and N contents are measured every depth at a pitch of 0.1 $\mu$m or less across the thickness, further nine locations (ten locations in total), and the site averages are averaged (overall average). The overall average value C/(C+N) is defined as the C content.

In crystal grains containing only a variable amount of Al or both variable amounts of Al and V, the average $X_{max}$ of the maxima $X_{max}^*$ and the average $X_{min}$ of the minima $X_{min}^*$ of the Al content X, and the average $Y_{max}$ of the maxima $Y_{max}^*$ and the average $Y_{min}$ of the minima $Y_{min}^*$ of the V content Y, and the area percent of crystal grains containing specified variable amounts of Al and V to the (AlVTi)CN layer can be determined, for example, as follows.

The longitudinal section of the (AlVTi) CN layer is observed at an appropriate magnification ranging from 16,000x to 320,000x with an energy-dispersive X-ray spectrometer attached to a scanning transmission electron microscope (STEM).

A rectangular field of view with a longitudinal length including the entire thickness of the (AlVTi)CN layer and a transverse length of at least 2 $\mu$m parallel to the surface of the substrate is selected in the longitudinal section of the (AlVTi) CN layer, and the Al content (X) in the total amount of V, Ti and Al and the V content (Y) in the total amount of V, Ti and Al are determined over the entire field of view.

The distribution of the Al content (X) in the total amount of V, Ti, and Al and the V content (Y) in the total amount of V, Ti, and Al are determined for each crystal grain (not limited to those of a NaCl-type face-centered cubic structure) in the entire observation field of view. If both maximum $X_{max}^*$ and minimum $X_{min}^*$ of the Al content (X) or maximum $Y_{max}^*$ and minimum $Y_{min}^*$ of the V content (Y) differ by $\pm 1\%$ or more from the average values $X_{avg}^*$ and $Y_{avg}^*$ of X and Y, the crystal grains are determined to contain only a variable amount of Al (having a non-uniform composition) or to contain both variable amounts of Al and V (having a non-uniform composition).

In other words, crystal grains containing only a variable amount of Al or both variable amounts of Al and V are defined by a region where the crystal grains determined to contain Al in only a variable amount or Al and V in both variable amounts are grouped together (summed). The averages of the maxima $X_{max}^*$ and minima $X_{min}^*$ measured in individual

crystal grains are defined as the maximum $X_{max}$ and minimum $X_{min}$, respectively, and the averages of the maxima $Y_{max}^*$ and minima $Y_{min}^*$ measured in individual crystal grains are defined as the maximum $Y_{max}$ and minimum $Y_{min}$, respectively.

It is more preferable that the regions where the difference between the average value $X_{avg}^*$ of X in the region containing Al in a variable amount is +1% or more (high Al-containing regions) and the regions where the difference is -1% or more (low Al-containing regions) are distributed in a network, layered or granular manner. It is even more preferred that the minimum distance between the outer edges of the high Al-containing regions separated by the low Al-containing regions or between the outer edges of the low Al-containing regions separated by the high Al-containing regions is 1 nm or more and 50 nm or less, for the following reasons:

At a minimum value within this range of the interval of Al content change, the heat cracking and chipping resistance of the coated tool is improved. A value of less than 1 nm may lead to an insufficient improvement in heat cracking resistance, whereas a value of 50 nm or more may lead to an insufficient improvement in chipping resistance.

The percentage of the total area of crystal grains containing a specified variable amount of Al and the percentage of the total area of crystal grains containing specified variable amounts of Al and V in the observation field of view are respectively defined as the area percentage occupied by crystal grains containing specified variable amount of Al in the (AlVTi)CN layer and the area percentage occupied by crystal grains containing specified variable amounts of Al and V in the (AlVTi)CN layer.

Even if the (AlVTi)CN layer contains inevitable impurities (impurities that are unintentionally included), such as a trace amount of oxygen, they do not hinder the achievement of the object of the invention.

(4) Value of Z

The Cl content in the (AlVTi)CN layer is determined, for example, by irradiation of a sample having a polished longitudinal section with electron beams in EPMA, and by analysis of the observed characteristic X-rays.

The above description includes features that are described in the following Appendices.

(Appendix 1)

A surface coated cutting tool comprising a substrate and a coating layer on a surface of the substrate, wherein

(a) the coating layer comprises a complex nitride or carbonitride layer of Ti, Al and V in a form of columnar crystal grains of a NaCl-type face-centered cubic structure,
(b) the complex nitride or carbonitride is represented by the formula: $(Al_X V_Y Ti_{1-X-Y})(C_\alpha N_{1-a})$ (wherein the average values $X_{avg}$, $Y_{avg}$ and $\alpha_{avg}$ of X, Y and $\alpha$, satisfy the relations: $0.600 \leq X_{avg} \leq 0.950$, $0.010 \leq Y_{avg} \leq 0.300$, $0.610 \leq X_{avg} +_{Yavg} \leq 0.990$ and $0.0000 \leq \alpha_{avg} \leq 0.0050$),
(c) the complex nitride or carbonitride comprises crystal grains containing a variable amount X of Al, wherein the average $X_{max}$ of the maxima $X_{max}^*$ and the average $X_{min}$ of the minima $X_{min}^*$ of X in the crystal grains satisfy the relations: $0.020 \leq X_{max}-X_{min} \leq 0.400$, and $0.020 \leq X_{max}-X_{min} \leq 0.400$, and
(d) A* (nm) represented by $A^* = 0.4045 X_{avg} + 0.4130 Y_{avg} + 0.4242 (1-X_{avg}-Y_{avg})$ and the lattice constant A (nm) calculated from an XRD pattern satisfy the relation: $|A-A^*|<0.0010(nm)$.

(Appendix 2)

The surface coated cutting tool according to Appendix 1, where the complex nitride or carbonitride layer comprises crystal grains containing both a variable amount of Al and a variable amount of V, and the average Ymax of the maxima Ymax* and the average Ymin of the minima Ymin* of Y satisfy the relation: $0.010 \leq Y_{max}-Y_{min} \leq 0.200$.

(Appendix 3)

The surface coated cutting tool according to Appendix 1, wherein the crystal grains containing a variable amount of Al are 50 area percent or more and 100 area percent or less in a longitudinal section.

(Appendix 4)

The surface coated cutting tool according to any one of Appendices 1 to 3, wherein in the crystal containing a variable amount of Al, the minimum distance between the outer edges of the high Al content region separated by the low Al content region or between the outer edges of the low Al content region separated by the high Al content region is 1 nm or more and 50 nm or less.

(Appendix 5)

The surface coated cutting tool according to Appendix 2, wherein the crystal grains containing both the variable amount of Al and the variable amount of V occupy more than 50 area percent and less than 100 area percent in the longitudinal section.

(Appendix 6)

The surface coated cutting tool according to any one of Appendices 1 to 5, wherein the columnar crystal grains of the NaCl-type face-centered cubic structure are contained in 50 area percent or more in the longitudinal section.

(Appendix 7)

The surface coated cutting tool according to any one of Appendices 1 to 6, wherein the columnar crystal grains of the NaCl type face-centered cubic structure have an aspect ratio of 1.5 or more.

(Appendix 8)

The surface coated cutting tool according to any one of Appendices 1 to 7, wherein the percentage Z of the number of Cl atoms to the total number of Al, Ti, V, C, N and Cl atoms is 0.005 atom% or more and 0.500 atom% or less.

**Examples**

The present invention will now be described by way of examples, which are not construed to limit the invention. Although the examples mention insert cutting tools including substrates made of WC-based cemented carbide, the substrate can be made of any of the aforementioned materials, and the tool can be in the form of a drill or in any other form, as described above.

1. Production of substrate

Raw powder materials of WC, TiC, TaC, NbC, $Cr_3C_2$, and Co were prepared. These powder materials were compounded into compositions described in Table 1, were ball-milled together with wax in acetone for 24 hours, and after being dried under reduced pressure, were pressed under a pressure of 98 MPa into green compacts with a specified shape.

The green compacts was each sintered at a temperature of 1420°C for 1 hour under a vacuum of 5 Pa, and then the cutting edges were processed to produce Substrates a to c made of WC base cemented carbide having a shape of Mitsubishi Materials SEMT13T3AGSN-JM insert honed to R of 0.06 mm on the cutting edge, or the cutting edges were processed to produce Substrates d to f made of WC base cemented carbide having a shape of Mitsubishi Materials CNMG120408-MA insert honed to R of 0.05 mm.

2. Deposition

(AlVTi)CN layers were deposited on the surfaces of Substrates a to f in a CVD system to produce Examples 1 to 11 shown in Table 5. The deposition conditions were as shown in Table 2, and were generally as follows.

Composition of reaction gas (content (%) of gas component) is volume % to the sum, 100 volume %, of Gas group A and Gas group B:

Gas group A:
$TiCl_4$: 0.01 to 0.30%, $AlCl_3$: 0.30 to 1.60%, $VCl_4$: 0.05 to 0.70%, Ar: 5.0 to 10.0%, $N_2$: 0.0 to 10.0%, $C_2H_4$: 0.0 to 0.5%, $H_2$: balance
Gas group B:
$NH_3$: 1.00 to 3.50%, $N_2$: 0.0 to 12.0%, $H_2$: 30.0 to 50.0%.

Pressure of reaction atmosphere: 4.0 to 5.0 kPa
Temperature of reaction atmosphere: 700 to 900°C

Gas group A and gas group B supplied correspond to raw material gas A and raw material gas B, respectively, in the CVD system described in Japanese patent No. 6358420. The rotational speed of the gas supply pipe, the distance (14) between the center (11) of the outer circumferential opening end of the port for gas group A (7) and the center (12) of the outer circumferential opening end of the port for gas group B (8) of the gas supply pipe, and the angle (15) determined by projecting an angle defined by the center (11) of the outer opening end of the port for gas group A (7) and the center (12) of the outer opening end of the port for gas group B (8) onto a plane perpendicular to the rotary axis are as follows:

Rotation speed of gas supply pipe: 30 rpm
Distance (14): 6 mm
Angle (15): 16 degrees

In some of Examples 1 to 11, only an underlying layer or an underlying layer and an overlying layer were deposited as shown in Table 4 according to the conditions shown in Table 3.

For comparison, (AlVTi)CN layers were deposited on the surfaces of substrates a to f according to the conditions for deposition shown in Table 2 to yield Comparative Examples 1 to 10 shown in Table 5.

In Examples, gas group A and gas group B were separately fed in the space inside the reaction vessel of the thermal CVD system and gas group A and gas group B were mixed just before gas group A and gas group B reach the target to be reacted. In Comparative Example, the raw material gases were fed into the reaction vessel of the thermal CVD system from a single gas supply pipe without being separated into two groups. A gas supply pipe was accordingly used that had no pair of ports for distinction between the port for gas group A (9) and the port for gas group B (10).

In some of Comparative Examples 1 to 10, only an underlying layer or both an underlying layer and an overlying layer were deposited as shown in Table 4 according to the conditions shown in Table 3.

[Table 1]

| Type | | Composition (mass%) | | | | | | | |
|------|---|------|------|------|------|------|-------|------|---------|
| | | Co | TiC | ZrC | TaC | NbC | Cr$_3$C$_2$ | TiN | WC |
| Substrate | a | 8.0 | 1.6 | 0.0 | 0.0 | 2.8 | 0.3 | 0.0 | Balance |
| | b | 8.0 | 0.0 | 0.0 | 1.6 | 0.5 | 0.0 | 0.0 | Balance |
| | c | 8.5 | 0.0 | 0.0 | 0.0 | 0.0 | 0.0 | 0.0 | Balance |
| | d | 7.0 | 0.0 | 1.2 | 0.0 | 2.9 | 0.5 | 1.0 | Balance |
| | e | 6.0 | 2.1 | 0.0 | 3.2 | 1.8 | 0.0 | 1.3 | Balance |
| | f | 8.0 | 0.0 | 0.0 | 0.0 | 0.0 | 0.2 | 0.0 | Balance |

[Table 2]

| Type of deposition process | Symbol of Process | Deposition of (AlVTi)CN layer (Composition of reaction gases is represented by percentage of sum of Gas Group A and Gas Group B.) | | | | | | | | | | | |
|---|---|---|---|---|---|---|---|---|---|---|---|---|---|
| | | Composition of Reaction Gas Group A (volume %) | | | | | | | Composition of Reaction Gas Group B (volume %) | | | Reaction Atmosphere | |
| | | TiCl$_4$ | AlCl$_3$ | VCl$_4$ | Ar | N$_2$ | C$_2$H$_4$ | H$_2$ | NH$_3$ | N$_2$ | H$_2$ | Pressure (kPa) | Temp. (°C) |
| Process of Examples | A | 0.06 | 0.30 | 0.07 | 5.3 | 10.0 | 0.5 | Balance | 1.10 | 0.0 | 45.0 | 4.0 | 800 |
| | B | 0.01 | 0.90 | 0.19 | 5.0 | 0.0 | 0.0 | Balance | 1.90 | 0.0 | 50.0 | 4.8 | 700 |
| | C | 0.15 | 0.61 | 0.26 | 7.8 | 2.0 | 0.4 | Balance | 1.80 | 6.0 | 35.0 | 4.2 | 750 |
| | D | 0.19 | 0.30 | 0.05 | 9.6 | 4.2 | 0.2 | Balance | 1.00 | 12.0 | 30.0 | 4.5 | 900 |
| | E | 0.05 | 0.30 | 0.70 | 10.0 | 8.8 | 0.0 | Balance | 1.50 | 4.0 | 35.0 | 5.0 | 850 |
| | F | 0.30 | 1.60 | 0.15 | 8.0 | 5.0 | 0.1 | Balance | 3.50 | 3.0 | 40.0 | 4.5 | 800 |
| Process of Comparative Examples | A' | 1.10 | 2.00 | 0.00 | 0.0 | 2.0 | 0.0 | Balance | 5.20 | 0.0 | 40.0 | 4.5 | 750 |
| | B' | 0.80 | 4.20 | 0.72 | 0.0 | 0.0 | 0.0 | Balance | 9.90 | 2.0 | 35.0 | 5.0 | 800 |
| | C' | 0.15 | 0.82 | 4.45 | 3.0 | 1.0 | 0.2 | Balance | 6.10 | 0.0 | 60.0 | 5.5 | 650 |
| | D' | 0.92 | 1.10 | 0.80 | 0.0 | 0.0 | 0.0 | Balance | 3.50 | 9.0 | 55.0 | 4.5 | 850 |
| | E' | 0.04 | 2.40 | 0.47 | 0.0 | 0.0 | 0.4 | Balance | 9.70 | 5.0 | 50.0 | 5.5 | 850 |

[Table 3]

| Type | | Condition of deposition | | |
|---|---|---|---|---|
| | | Composition of reaction gas (volume %) | Reaction atmosphere | |
| | | | Pressure (kPa) | Temp. (°C) |
| Ti compound layer | TiN | $TiCl_4$: 42%, $N_2$: 30%, H2: Balance | 7.0 | 800 |
| | TiCN | $TiCl_4$: 2%, $CH_3CN$: 0.7%, $N_2$: 10%, $H_2$: Balance | 7.0 | 800 |
| | TiCNO | $TiCl_4$: 2%, $CH_3CN$: 1.7%, CO: 1%, $N_2$: 10%, $H_2$: Balance | 7.0 | 800 |
| $Al_2O_3$ layer | $Al_2O_3$ | $AlCl_3$: 2.2%, $CO_2$: 5.5%, HCl: 2.2%, $H_2S$: 0.2%, $H_2$: Balance | 7.0 | 800 |

[Table 4]

| Type | | Coating layer (The lower number indicates the average thickness of the layer (μm)) | | | | |
|---|---|---|---|---|---|---|
| | | Underlying layer | | Overlaying layer | | |
| | | First sublayer | Second sublayer | First sublayer | Second sublayer | Third sublayer |
| Examples and Comparative Examples | 1 | – | – | – | – | – |
| | 2 | TiN (0.3) | – | – | – | – |
| | 3 | TiN (0.5) | TiCN (1.5) | – | – | – |
| | 4 | TiN (1.0) | – | – | – | – |
| | 5 | TiN (0.3) | TiCN (1.7) | TiCN (1.0) | TiCNO (0.3) | $Al_2O_3$ (2.0) |

In Table 4, symbol "-" indicates that no layer is formed, and Type 1 indicates that neither an underlying layer nor an overlying layer is formed.

[Table 5]

Table 5 demonstrates that the analytical detection limits are 0.001 for $Y_{avg}$, 0.0001 for $\alpha_{avg}$, and 0.001 atomic percent for Z, and thus $Y_{avg}$ and Z can be regarded as 0.000 and $\alpha_{avg}$ as 0.0000. The symbol "-" in $Y_{max}$-$Y_{min}$ indicates that $Y_{avg}$ is less than 0.001 and the V element is below the detection limit; hence, $Y_{max}$-$Y_{min}$ cannot be calculated (invariable

| | Type | Substrate | Process of symbol | Underlying layer and overlying layer | Average thickness ($\mu$m) | Area percent of grains with NaCl type face-centered cubic structure (%) | Area percent of crystal grains with NaCl-type face-centered cubic structure and aspect ratio of 1.5 or higher (%) | Area percent of crystal grains with NaCl-type face-centered cubic structure and aspect ratio of 2.0 or greater (%) | (AlVTi)CN layer | | | | | | | | | | | |
| | | | | | | | | | Content | | | | | Variable content | | | | | Lattice constant | | |
| | | | | | | | | | $X_{avg}$ | $Y_{avg}$ | $X_{aavg}$+$Y_{avg}$ | $\alpha_{avg}$ | Z (atomic %) | $X_{max}$-$X_{min}$ | $Y_{max}$-$Y_{min}$ | Area percent of relevant crystals (%) | Presence in network, layered, and granular forms | Minimum distance between outer edges of each region (nm) | $A^*$ | $A$ | $|A-A^*|$ |
|---|---|---|---|---|---|---|---|---|---|---|---|---|---|---|---|---|---|---|---|---|---|
| Examples | 1 | a | A | 2 | 1.1 | 81 | 79 | 70 | 0.799 | 0.037 | 0.836 | 0.0050 | 0.008 | 0.089 | 0.008 | 68 | ○ | 19 | 0.4080 | 0.4085 | 0.0005 |
| | 2 | b | B | 1 | 4.2 | 67 | 67 | 61 | 0.948 | 0.041 | 0.989 | 0.0001> | 0.512 | 0.022 | 0.011 | 52 | ○ | 2 | 0.4051 | 0.4060 | 0.0009 |
| | 3 | c | C | 4 | 2.0 | 86 | 86 | 81 | 0.750 | 0.065 | 0.815 | 0.0038 | 0.394 | 0.391 | 0.055 | 77 | ○ | 88 | 0.4087 | 0.4090 | 0.0003 |
| | 4 | b | D | 3 | 6.7 | 99 | 96 | 91 | 0.604 | 0.019 | 0.623 | 0.0019 | 0.002 | 0.096 | 0.015 | 94 | ○ | 25 | 0.4121 | 0.4118 | 0.0003 |
| | 5 | c | E | 2 | 9.2 | 78 | 75 | 68 | 0.609 | 0.284 | 0.893 | 0.0001> | 0.045 | 0.322 | 0.206 | 56 | ○ | 65 | 0.4090 | 0.4097 | 0.0007 |
| | 6 | d | A | 3 | 11.6 | 77 | 77 | 72 | 0.805 | 0.035 | 0.840 | 0.0048 | 0.015 | 0.096 | 0.008 | 72 | ○ | 31 | 0.4079 | 0.4083 | 0.0004 |
| | 7 | e | B | 2 | 19.8 | 69 | 67 | 62 | 0.941 | 0.044 | 0.985 | 0.0001> | 0.530 | 0.020 | 0.010 | 54 | ○ | 2 | 0.4052 | 0.4060 | 0.0008 |
| | 8 | f | C | 5 | 14.2 | 82 | 81 | 74 | 0.757 | 0.066 | 0.823 | 0.0039 | 0.312 | 0.379 | 0.047 | 67 | ○ | 74 | 0.4085 | 0.4091 | 0.0006 |
| | 9 | d | D | 5 | 19.1 | 100 | 100 | 98 | 0.603 | 0.021 | 0.624 | 0.0021 | 0.001> | 0.103 | 0.018 | 96 | ○ | 44 | 0.4121 | 0.4120 | 0.0001 |
| | 10 | f | E | 4 | 17.4 | 80 | 78 | 71 | 0.616 | 0.269 | 0.885 | 0.0001> | 0.031 | 0.305 | 0.195 | 66 | ○ | 54 | 0.4091 | 0.4095 | 0.0004 |
| | 11 | b | F | 2 | 7.5 | 68 | 64 | 59 | 0.832 | 0.057 | 0.889 | 0.0011 | 0.127 | 0.142 | 0.005 | 62 | ○ | 37 | 0.4072 | 0.4077 | 0.0005 |
| Comparative Examples | 1 | a | A' | 3 | 1.5 | 84 | 82 | 77 | 0.641 | 0.001> | 0.641 | 0.0001> | 0.009 | 0.112 | – | 71 | ○ | 68 | 0.4116 | 0.4103 | 0.0013 |
| | 2 | b | B' | 2 | 4.2 | 72 | 70 | 66 | 0.842 | 0.006 | 0.848 | 0.0001> | 0.029 | 0.096 | 0.002 | 61 | ○ | 31 | 0.4075 | 0.4088 | 0.0013 |
| | 3 | c | C' | 1 | 5.5 | 69 | 69 | 61 | 0.577 | 0.314 | 0.891 | 0.0019 | 0.032 | 0.145 | 0.212 | 52 | ○ | 49 | 0.4093 | 0.4111 | 0.0018 |
| | 4 | a | D' | 4 | 2.6 | 76 | 74 | 70 | 0.534 | 0.016 | 0.550 | 0.0001> | 0.005 | 0.116 | 0.004 | 63 | ○ | 65 | 0.4135 | 0.4121 | 0.0014 |
| | 5 | b | E' | 2 | 8.4 | 22 | 11 | 3 | 0.972 | 0.008 | 0.980 | 0.0041 | 1.121 | 0.018 | 0.003 | 8 | – | – | 0.4050 | 0.4071 | 0.0021 |
| | 6 | d | A' | 5 | 10.2 | 85 | 82 | 76 | 0.652 | 0.001> | 0.652 | 0.0001> | 0.009 | 0.109 | – | 72 | ○ | 65 | 0.4114 | 0.4103 | 0.0011 |
| | 7 | e | B' | 5 | 13.5 | 79 | 74 | 71 | 0.833 | 0.006 | 0.839 | 0.0001> | 0.022 | 0.088 | 0.003 | 61 | ○ | 26 | 0.4077 | 0.4088 | 0.0011 |
| | 8 | f | C' | 2 | 11.9 | 66 | 66 | 62 | 0.584 | 0.314 | 0.898 | 0.0018 | 0.046 | 0.142 | 0.201 | 55 | ○ | 48 | 0.4092 | 0.4112 | 0.0020 |
| | 9 | d | D' | 3 | 17.2 | 76 | 74 | 69 | 0.539 | 0.016 | 0.555 | 0.0001> | 0.003 | 0.129 | 0.008 | 65 | ○ | 71 | 0.4134 | 0.4122 | 0.0012 |
| | 10 | f | E' | 4 | 16.6 | 37 | 15 | 3 | 0.978 | 0.008 | 0.986 | 0.0039 | 1.049 | 0.015 | 0.002 | 5 | – | – | 0.4048 | 0.4070 | 0.0022 |

content).

The "existence in network, layered, or granular" means that "regions with a difference of +1% or more (high Al content regions) and regions with a difference of -1% or more (low Al content regions) from the average value ($X_{avg}$*) of X in the region containing variable amounts of Al and Ti are distributed in a network, layered, or granular state. In Table 5, "○" indicates that "existence in network, layered, or granular", and "-" indicates that "non-existence in network, layered, or granular". The "minimum distance between the outer edges of each area" means "the distance between the outer edges of the high Al content area separated by the low Al content area, or the distance between the outer edges of the low Al content area separated by the high Al content area.

The substrates of Examples 1 through 11 and Comparative Examples 1 through 10 were each clamped to the tip of a tool steel cutter with a cutter diameter of 125 mm, and was subjected to the following cutting tests 1 and 2 to measure the flank wear width of the cutting edge.

Cutting Test 1: Dry high-speed front face milling, center cutting
Cutter diameter: 125mm
Workpiece: JIS S55C block material 100 mm wide and 400 mm long
Rotation speed: 891/min
Cutting speed: 350 m/min
Depth of cut: 2.0mm
Feed rate per blade: 0.2 mm/edge
Cutting time: 20.2 minutes
(Cf. Normal cutting speed: 150 to 250 m/min)
Cutting Test 2: Dry high-speed intermittent cutting
Workpiece: JIS S55C round bar with four longitudinal grooves equally spaced along its length
Cutting speed: 300 m/min
Depth of cut: 2.0mm
Feed: 0.2 mm/rev
Cutting time: 10 min
(Cf. Normal cutting speed: 150 to 200 m/min)

Tables 6 and 7 show the results of cutting test 1 and cutting test 2, respectively. In comparative examples 1 to 10, the life time (minutes) to the end of life is shown instead of the flank wear width (mm) because the tool reached the life time due to chipping before the end of the cutting time.

[Table 6]

| Cutting test 1 | | | | | |
|---|---|---|---|---|---|
| Type | | Flank wear width (mm) | Type | | Cutting time to life (min) |
| Examples | 1 | 0.11 | Comparative Examples | 1 | 15.7 |
| | 2 | 0.16 | | 2 | 11.2 |
| | 3 | 0.08 | | 3 | 9.0 |
| | 4 | 0.10 | | 4 | 13.5 |
| | 5 | 0.12 | | 5 | 4.5 |
| | 11 | 0.20 | | | |

[Table 7]

| Cutting test 2 | | | | | |
|---|---|---|---|---|---|
| Type | | Flank wear width (mm) | Type | | Cutting time to life (min) |
| Examples | 6 | 0.07 | Comparative Examples | 6 | 8 |
| | 7 | 0.10 | | 7 | 6 |
| | 8 | 0.12 | | 8 | 4 |
| | 9 | 0.08 | | 9 | 5 |
| | 10 | 0.14 | | 10 | 1 |

Tables 6 and 7 evidentially show that Examples all show no chipping, improved chipping resistance, and excellent cutting performance over a long period of time.

In contrast, Comparative examples 1 to 10 undergone chipping before the end of the cutting time and reached the end of service life within a short period of time.

The disclosed embodiments are in all respects illustrative only and are not restrictive. The scope of the invention is indicated by the claims, not the aforementioned embodiments, and is intended to include all modifications within the gist and scope of the claims and equivalents.

**Reference Numerals**

1 substrate
2 coating layer
3 (AlVTi)CN layer
4 underlying layer
5 overlying layer
6 gas supply pipe
7 port of Gas group A
8 port of Gas group B
9 Gas group A distribution segment
10 Gas group B distribution segment
11 center of outer opening end of port of Gas group A
12 center of the outer opening end of port of gas group B
13 center of rotation axis
14 distance
15 angle

**Claims**

1. 1. A surface coated cutting tool comprising a substrate and a coating layer on a surface of the substrate, wherein

(a) the coating layer comprises complex nitride or carbonitride of Ti, Al and V in a form of columnar crystal grains of a NaCl-type face-centered cubic structure,
(b) the complex nitride or carbonitride is represented by the formula: $(Al_X V_Y Ti_{1-X-Y})(C_\alpha N_{1-\alpha})$ (wherein the average values $X_{avg}$, $Y_{avg}$ and $\alpha_{avg}$ of X, Y and $\alpha$, satisfy the relations: $0.600 \leq X_{avg} \leq 0.950$, $0.010 \leq Y_{avg} \leq 0.300$, $0.610 \leq X_{avg}+Y_{avg} \leq 0.990$ and $0.0000 \leq \alpha_{avg} \leq 0.0050$),

(c) the complex nitride or carbonitride comprises crystal grains containing a variable amount X of Al, wherein the average $X_{max}$ of the maxima $X_{max}^*$ and the average $X_{min}$ of the minima $X_{min}^*$ of X in the crystal grains satisfy the relations: $0.020 \leq X_{max}\text{-}X_{min} \leq 0.400$, and $0.020 \leq X_{max}\text{-}X_{min} \leq 0.400$, and

(d) $A^*$ (nm) represented by $A^* = 0.4045X_{avg} + 0.4130Y_{avg} + 0.4242 (1\text{-}X_{avg}\text{-}Y_{avg})$ and the lattice constant A (nm) calculated from an XRD pattern satisfy the relation: $|A\text{-}A^*|<0.0010(nm)$.

2. The surface coated cutting tool as claimed in claim 1, where the complex nitride or carbonitride layer comprises crystal grains containing both a variable amount of Al and a variable amount of V, and the average $Y_{max}$ of the maxima $Y_{max}^*$ and the average $Y_{min}$ of the minima $Y_{min}^*$ of Y satisfy the relation: $0.010 \leq Y_{max}\text{-}Y_{min} \leq 0.200$.

[Fig. 1]

[Fig. 2]

[Fig. 3]

## INTERNATIONAL SEARCH REPORT

| International application No. |
| --- |
| **PCT/JP2023/011414** |

| | |
| --- | --- |
| **A.** | **CLASSIFICATION OF SUBJECT MATTER** |
| | ***B23B 27/14***(2006.01)i; ***C23C 16/34***(2006.01)i; ***C23C 16/36***(2006.01)i<br>FI: B23B27/14 A; C23C16/34; C23C16/36 |

According to International Patent Classification (IPC) or to both national classification and IPC

| | |
| --- | --- |
| **B.** | **FIELDS SEARCHED** |

Minimum documentation searched (classification system followed by classification symbols)
B23B27/14; B23C5/16; C23C16/00-16/56; C23C14/00-14/58

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

| | |
| --- | --- |
| **C.** | **DOCUMENTS CONSIDERED TO BE RELEVANT** |

| Category* | Citation of document, with indication, where appropriate, of the relevant passages | Relevant to claim No. |
| --- | --- | --- |
| A | WO 2020/137325 A1 (NGK SPARK PLUG CO., LTD.) 02 July 2020 (2020-07-02) | 1-2 |
| A | JP 2011-224686 A (MITSUBISHI MATERIALS CORP.) 10 November 2011 (2011-11-10) | 1-2 |
| A | JP 2001-181826 A (MMC KOBELCO TOOL KK) 03 July 2001 (2001-07-03) | 1-2 |
| A | JP 2017-30076 A (MITSUBISHI MATERIALS CORP.) 09 February 2017 (2017-02-09) | 1-2 |
| A | JP 2016-137549 A (MITSUBISHI MATERIALS CORP.) 04 August 2016 (2016-08-04) | 1-2 |
| A | JP 2016-64485 A (MITSUBISHI MATERIALS CORP.) 28 April 2016 (2016-04-28) | 1-2 |

☐ Further documents are listed in the continuation of Box C.　　☑ See patent family annex.

| | | | |
| --- | --- | --- | --- |
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
| --- | --- |
| **12 April 2023** | **09 May 2023** |

| Name and mailing address of the ISA/JP | Authorized officer |
| --- | --- |
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (January 2015)

## INTERNATIONAL SEARCH REPORT
### Information on patent family members

International application No.

**PCT/JP2023/011414**

| Patent document cited in search report | | | Publication date (day/month/year) | Patent family member(s) | | | Publication date (day/month/year) |
|---|---|---|---|---|---|---|---|
| WO | 2020/137325 | A1 | 02 July 2020 | US | 2022/0001457 | A1 | |
| | | | | EP | 3903975 | A1 | |
| | | | | KR | 10-2021-0063427 | A | |
| | | | | CN | 113260475 | A | |
| JP | 2011-224686 | A | 10 November 2011 | (Family: none) | | | |
| JP | 2001-181826 | A | 03 July 2001 | (Family: none) | | | |
| JP | 2017-30076 | A | 09 February 2017 | (Family: none) | | | |
| JP | 2016-137549 | A | 04 August 2016 | (Family: none) | | | |
| JP | 2016-64485 | A | 28 April 2016 | US | 2017/0297117 | A1 | |
| | | | | EP | 3103572 | A1 | |
| | | | | CN | 106457413 | A | |
| | | | | KR | 10-2017-0057375 | A | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2022056505 A
- JP H10237628 A

- JP 6358420 B

**Non-patent literature cited in the description**

- *Bulletin of the Japan Institute of Metals*, 1989, vol. 28 (3), 189